# EUROPEAN PATENT SPECIFICATION

(11) **EP 3 217 183 B1**
(45) Date of publication and mention of the grant of the patent: **01.05.2019**
(21) Application number: 16159029.4
(22) Date of filing: 07.03.2016
(51) Int. Cl.: G01R 31/319, H05K 13/00, G01R 1/02, G01R 31/28, H01L 21/67, H05K 13/08

(54) **A POSITIONING DEVICE AND A SYSTEM FOR DETERMINING A SITE OF A WEAR PART OF A HANDLER**
POSITIONIERUNGSVORRICHTUNG UND SYSTEM ZUR BESTIMMUNG EINES STANDORTS EINES VERSCHLEISSTEILS EINES HANDLERS
DISPOSITIF DE POSITIONNEMENT ET SYSTÈME PERMETTANT DE DÉTERMINER L'EMPLACEMENT D'UNE PIÈCE D'USURE D'UN MANIPULATEUR

(43) Date of publication of application: 13.09.2017
(73) Proprietor: Multitest elektronische Systeme GmbH, 83026 Rosenheim (DE)
(72) Inventor: Fritsche, Thomas, 86567 Hilgertshausen (DE); Petermann, Manuel, 83022 Rosenheim (DE); Born, Gabriela, 85521 Ottobrunn (DE)
(74) Representative: Dilg, Haeusler, Schindelmann Patentanwaltsgesellschaft mbH

(56) References cited:
- JP-A- 2011 247 908
- US-A- 5 014 002
- US-A1- 2009 309 620
- US-A1- 2015 046 627

## Description

### Field of invention

An embodiment of the invention relates to a positioning device for determining a site of a wear part of a handler. Further, an embodiment of the invention relates to a system for determining a site of a wear part of a handler.

### Background of the invention

Testing of DUTs ("device under test") is a part of the backend process of producing semiconductor components. A so called "handler" moves, contacts and sorts the DUTs. A so called "tester" is a computer which runs the test program and evaluates the result of the test so that the handler may sort the DUTs. During a test period of thousands of DUTs certain components of the handler wear down. These wear components or parts of the handler need to be maintained or exchanged depending on the number of tests. Examples of handlers and the corresponding maintenance methods can be found in JP-2011 247908-A.

### Summary of the Invention

There may be a need to amend the maintenance processes and to amend the monitoring of the tests.

In order to meet the need defined above a positioning device for determining a site of a wear part of a handler and system for determining a site of a wear part of a handler are provided according to independent claims.

According to an embodiment of the invention a positioning device for determining a site of an exchangeable wear part of a handler comprises: (a) an electronic component arranged on the wear part, and (b) an electrical addressing device being readable for the electronic component, wherein (c) the electronic component is electrically connected to the electrical addressing device and wherein the electronic component fulfils specifications of a bus.

According to an embodiment of the invention a positioning system to determine a site of a wear part of a handler comprises (a) a plurality of the positioning devices and (b) a microcontroller master fulfilling the specifications of the bus and being coupled to the electronic component via the bus.

The expression "positioning device" may denote a device by which the position of a unit may be detected. The term "site" may denote a specific position of a subunit within a larger unit. The larger unit may be automated test equipment which is used to test DUTs under specific conditions. Automated test equipment may at least comprise a handler and a tester. The expression "wear part" may denote any expendable within the handler, in particular a component of the handler which may wear down due to mechanical stress. In particular, a socket or test socket, a lead backer, or a plunger may be wear parts of a handler.

The expression "electronic component" may denote any electronic device which fulfils specifications of a bus so that the electronic component may exchange digital signals with other electronic components via the bus. In particular, the electronic component may be an EEPROM, a microcontroller, a flash memory, or a DSP. A microcontroller may be a computing device (CPU) with integrated non-volatile memory (EEPROM/Flash). The microcontroller may comprise an A/D converter, and a standard bus interface (e.g. I2C). Further, the microcontroller may comprise a temperature sensor in order to support extended functionality such as temperature measurement. The term "arranged on" may denote attached to or mounted on. The expression "electrical addressing device" may denote analogue or passive electrical components which allow for an analogue and unique encoding. In particular, for each test site, the electrical addressing device may be unique. The electrical addressing device may comprise open contacts, jumpers, resistors, capacitors or coils to identify the electrical characteristics as unique. The expression "electrically connected" may denote a link by wire or wires. The expression "electrically connected" may, in particular, denote that the electrical addressing device may be read out via the electrical connection by the electronic component. I.e., the electrical characteristics of the specific electrical addressing device may be found out by the electronic component. A bus may be any standardized electronic interface such as an I2C bus, a CAN bus, or any other bus which allows for reading or writing digitalized information between electronic components.

A gist is that the electronic component is mounted on the wear part and that the wear part is exchangeable within the handler or between two handlers. Further, the electrical addressing device may be mounted within the handler so that the electrical addressing device is not changed if the wear part is changed. In particular, the electrical addressing device may be stationary relative to the site, stationary relative to the wear part, and/or stationary within the handler. By means of the electronic component the site which corresponds to the electrical addressing device may be obtained.

Hence, the wear part itself has means to determine its own site or position within the handler. As a consequence, the wear parts may be exchanged arbitrarily within or between handlers and the wear part automatically gains information about its position. Since the electronic component meets the bus specification, this may have the effect that the use of the wear part may be retraced and documented via the bus and no operator must actively support the documentation of the wear part use.

According to an exemplary embodiment of the positioning device the electronic component is adapted to transform an addressing of the electrical addressing device into a digital address signal and to transmit the digital address signal via the bus.

The electrical addressing device may comprise jumpers, open terminals, resistors, and/or capacitors, etc. which may be sensed by the electronic component. Then the electronic component may transform this physically or electrically given information or state into a digital address signal which corresponds to the specific electrical addressing device. In particular, the transmission via the bus may be digitally.

According to an exemplary embodiment of the positioning device, may the electrical addressing device be unique for each site of the handler.

The electrical addressing device may be unique and the obtained the digital address signal may be unique as well.

According to an exemplary embodiment of the positioning device, the electrical addressing device comprises jumpers, and/or resistors, and/or capacitors, and/or coils, being electrically coupled to address terminals of the electronic component.

The address terminals may be a part of the electronic component, whereas the electrical addressing device is not part of the electronic component but unique and stationary for the specific test site. That is, the electronic component may be exchanged with the wear part but the electrical addressing device comprising jumpers, and/or resistors, and/or capacitors, and/or coils may remain on or at the site if the wear part is exchanged. Since the electronic component is exchangeable along with the wear part, the electronic component may read out a variety of unique electrical addressing device corresponding to the specific site and may transform this physical or electrical information into the digital address signal which may be submitted by the bus. The addressing device mode of the electrical addressing device may be analogue whereas the bus signals are digital.

According to an exemplary embodiment the positioning device further comprises an interface board, wherein at least one of the group of the jumpers, the resistors, the capacitors, and the wear part is arranged on or at the interface board.

It may be appropriate to arrange the exchangeable wear part on the interface board and to arrange the electrical parts of the addressing device on the same interface board. In particular, the resistors may be attached to or arranged on the same interface board. However, since the wear part and the electrical addressing device may be mounted directly on the same interface board or on different interface boards which are then mounted to the same interface board a variety of solutions are possible.

According to an exemplary embodiment of the positioning device, is the specification of the bus an I2C bus.

The I2C bus may allow for 63 sub-addresses or wear parts to be digitally addressed. However the number may vary, depending on the length and complexity of the wiring for the electrical addressing device which needs to be connected via the I2C bus.

According to an exemplary embodiment of the positioning device the electronic component is an EEPROM on which an ID of the wear part is stored.

If an EEPROM is used the number of sub-addresses may be limited. In particular, the number of sub-addresses may be limited to 8, since the EEPROM allows only the use of 3 sub-address bits. However, storing an ID in the EEPROM makes it possible to retrace the use of numerous wear parts. The ID may be digitally encrypted to monitor the use of the wear parts.

According to an exemplary embodiment of the positioning device, does the electronic component a microcontroller slave comprise an internal EEPROM on which an ID of the wear part is stored.

If an internal EEPROM of a microcontroller slave is used the number of sub-addresses or wear parts may be enhanced compared to the use of a stand alone EEPROM. Due to the bus specifications of the I2C bus the number of sub-addresses or sites may be 126 for one I2C bus. Again, storing an ID in the EEPROM makes it possible to retrace the use of numerous wear parts (even more than 126). The ID may be digitally and the ID may be encrypted to monitor the use of the wear parts. An encryption program may run on the microcontroller. This may again be helpful to supervise the use of the wear parts.

According to an exemplary embodiment the positioning device further comprises a data matrix code being attached to the wear part.

The information on the data matrix code and the stored ID may correspond or coincide to each other. The information ID about the wear part may be unique for each wear part. Furthermore, the ID of the data matrix code gives the chance to read out the ID independently with an external reading device.

According to an exemplary embodiment of the positioning device, the microcontroller slave comprises a temperature sensor to determine a temperature value on the wear part and is adapted to send a digitalized temperature signal via the bus.

According to an exemplary embodiment of the positioning device the wear part is a socket and the microcontroller slave comprises an analogue terminal, wherein a voltage divider is coupled to the analogue terminal so that the microcontroller can sense if a DUT is contacted to the socket, or if no DUT is contacted to the socket.

According to a regular use of a voltage divider the microcontroller slave may sense if a DUT is contacted to the socket since the DUT may close a circuit which is grounded in case the DUT is contacted, and which circuit may be open when no DUT is contacted to the socket. Therefore, when a DUT is contacted the microcontroller may sense at its analogue terminal a lower voltage, since a voltage decay happens when the DUT circuit is grounded. If no DUT is contacted then the DUT circuit is open and the full voltage value coming from a power supply via a pull up resistor may be sensed at the analogue terminal of the microcontroller slave. Sensing, whether a DUT is contacted to the socket or not may be continuously and therefore independently of the tester which is "blind" during index time, when no DUT is contacted to the socket. As a result, the microcontroller slave may sense double device detection or prevent a "double device test". If there is a jam, i.e. a DUT is contacted because it is not taken off the socket after the test but remains on the socket, then the microcontroller slave may set a flag to a value 1 and this value may be submitted via the bus to the tester or handler which can interrupt the test period. Otherwise, the same DUT would be tested repeatedly and not the DUT which is supposed to be tested and sorted.

According to an exemplary embodiment of the positioning system the microcontroller master is programmed to request from the microcontroller slave at least one of the group of the digital address signal, the digitalized temperature signal, the ID, or a digitalized signal of a contacted DUT or of no contacted DUT.

The microcontroller master of the I2C bus may communicate with the microcontroller slave and with a tester and may send e.g. a request signal to the microcontroller slave whether a DUT is contacted to a socket or not.

According to an exemplary embodiment of the positioning system the microcontroller master is programmed to request from the microcontroller slave at least one of the group of the digital address signal, the digitalized temperature signal, the ID, or a digitalized signal of a contacted DUT or of no contacted DUT.

In communication with the tester and with the microcontroller slave, the microcontroller master may provide the gained information about the identity of the wear part, the contact situation of the socket, the temperature on the wear part and the digital address signal towards the tester and/or handler.

According to an exemplary embodiment of the positioning system the microcontroller master is arranged on or at a tester.
The tester may provide the environment for the microcontroller master so that the communication between the microcontroller master and the microcontroller slave is provided.

According to an exemplary embodiment of the positioning system, at least one of the group of the digital address signal, the digitalized temperature signal, the ID, and a digitalized signal of a contacted DUT or of no contacted DUT, is stored on a database.
The database may be arranged within the tester and/or handler and/or may be stored via internet in a cloud application.

### Brief Description of the Drawing

Fig.1 shows a schematic illustration of automated test equipment
Fig.2 shows a schematic illustration of a plan view of a socket
Fig.3 shows a schematic illustration of a positioning system with one socket
Fig.4 shows a schematic illustration of DUT detection
Fig.5 shows a schematic illustration of the circuitry of the positioning system
Fig.6 shows a schematic illustration of an EEPROM
Fig.7 shows a schematic illustration of a microcontroller slave
Fig.8 flow chart of the program running on the microcontroller slave

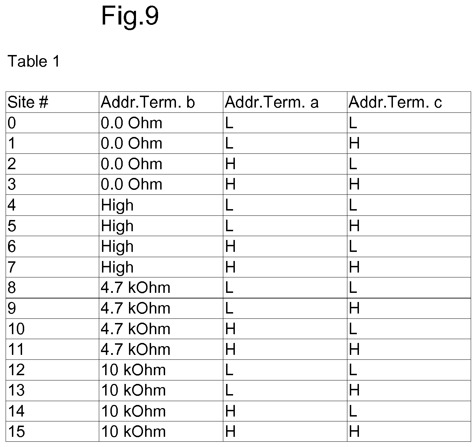

Fig.9 shows table 1 comprising the coding of the electrical addressing device

### Detailed Description of the Drawing

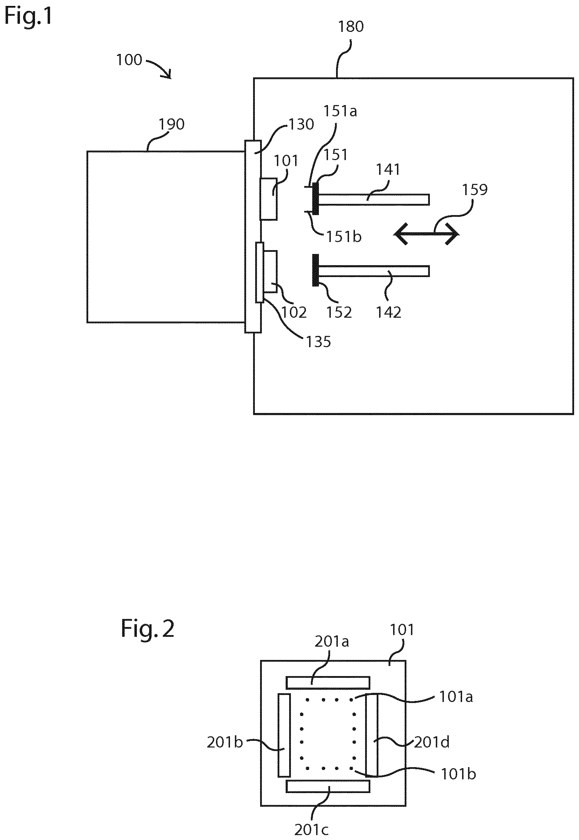

Fig.1 shows a schematic view of automated test equipment 100. Automated test equipment 100 comprises a tester 190 and a handler 180. Between the tester 190 and the handler 180 there is a first socket 101 arranged on a first interface board 130, or so called DUT board, extending over the whole area where sockets 101, 102 are arranged. The second socket 102 may be arranged on a second interface board 135 and the second interface board 135 may be arranged on the DUT board 130 so that there is a so called sandwiched arrangement given. A first and a second plunger 141, 142 may hold a first and a second DUT 151, 152, respectively. The two DUTs 151, 152 may be contacted to the first and second socket 101, 102, respectively, by a forward and backward movement 159 of the two plungers 141, 142, respectively. The first DUT 151 may comprise a first contact terminal 151a and a second contact terminal 151b.

Fig.2 shows the socket 101 in a plan view. The socket 101 comprises guiding elements, so called "lead backers" 201a, 201b, 201c and 201d which guide the DUT 151 so that the first contact terminal 151a and the second contact terminal 151b etc. of the DUT 151 may be correctly contacted with contacts 101a, 101b, etc. of the socket 101. Since the socket 101, the contacts 101a, 101b of the socket, the lead backers 201a, 201b, 201c and 201d and the plungers 141, 142 are mechanically stressed during every test procedure and wear down, all of these parts are wear parts which need maintenance and need to be replaced after a certain period of testing. All these wear parts 101, 102, 141, 142 and 201a to d are exchangeable parts of automated test equipment 100, and of the handler 180, respectively.

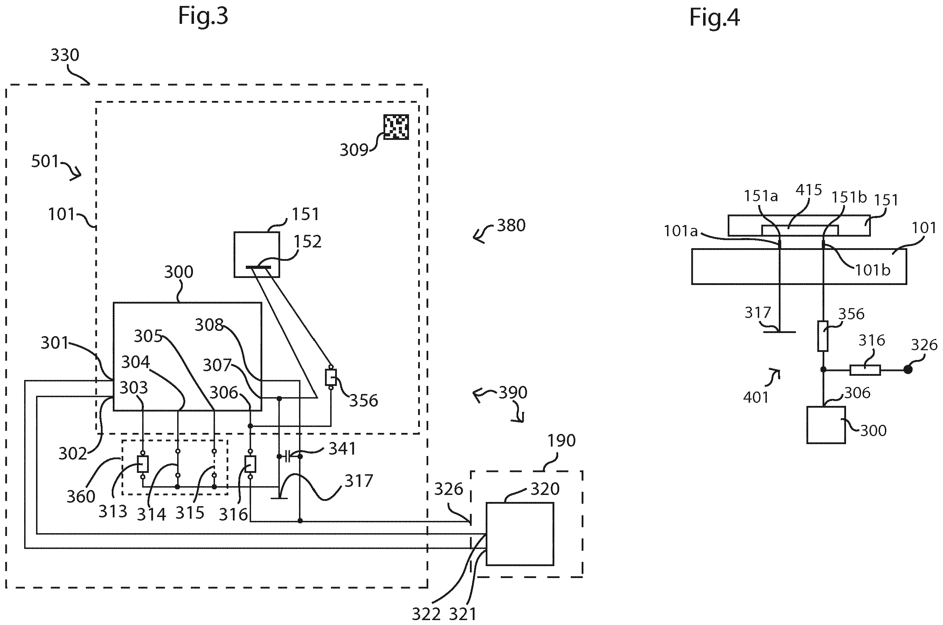

Fig.3 shows a schematic view of a positioning system 390 for detecting the position of an exchangeable wear part 101, 102, 141, 142 and 201a to d in automated test systems 100. In this depicted case, the wear part may be a socket 101. The positioning system 390 may comprise a positioning device 380 and microcontroller master 320. The microcontroller master 320 may be arranged in a tester 190 and may provide an SCL terminal 321 and an SDA terminal 322 which may be communication lines of an I2C Bus (or "Inter Integrated Circuit Bus", or so called TWI "two wire interface").
The positioning device 380 may comprise the socket 101 being attached to an interface board 330. The socket 101 may further comprise a data matrix code 309 and a microcontroller slave 300. The microcontroller slave 300 may have several terminals such as an SCL terminal 301 which may be electrically coupled to the SCL terminal 321 of the microcontroller master 320. For data exchange the microcontroller slave 300 may comprise an SDA terminal 302 which may be electrically coupled with the SDA terminal 322 of the microcontroller master 320. Thus, the serial two wire bus, which may be an I2C bus, may couple the microcontroller slave 300 with the microcontroller master 320. The microcontroller slave 300 may comprise three address terminals, which are the first address terminal 303, the second address terminal 304, and the third address terminal 305. Each of the three address terminals 303, 304, 305 may be crucial for the electrical addressing device 360 of the position (or site) of the microcontroller slave 300, since the three address terminals 303, 304, 305 may be open, coupled to grounding, or coupled to a specific resistor, having a specific value. The microcontroller slave 300 may be programmed to determine a specific electronic state of the three address terminals 303, 304, 305 and may calculate from a given table (see table 1) on which location, or so called "site" 501 the microcontroller slave 300, or socket 101, respectively, is attached to. The information about the site 501, that means, where the socket 101 is attached to, may be submitted to the microcontroller master 320 via the I2C bus and the SDA terminal 302 of the microcontroller slave 300. The microcontroller slave 300 may further comprise a VCC input 308 which may be supplied by a power supply 326 being arranged on the tester 190. The power supply 326 may be coupled to a grounding 317 via a capacitor 341 to avoid electronic problems during powering on of the microcontroller slave 300.

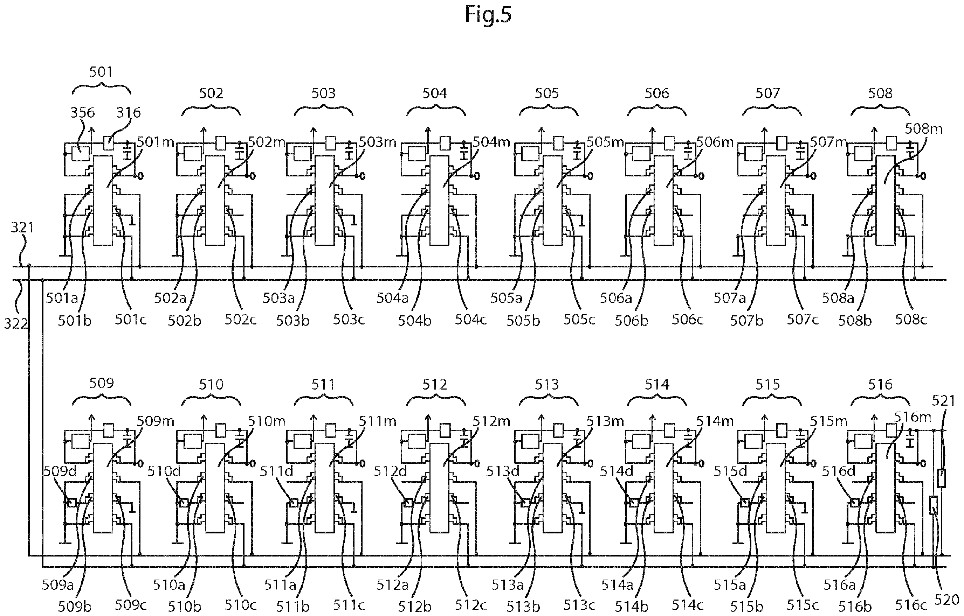

A DUT 151 may comprise a grounding plate 152 which is coupled both, to a voltage divider 401 - comprising pull up resistors 316 and a detection resistor 356 - , and to grounding 317. There is also a grounding terminal 307 of the microcontroller slave 300 which is coupled to the grounding 317. Further, the microcontroller slave 300 comprises an analogue terminal 306 which is coupled to the voltage divider 401. Thus, the microcontroller slave 300 may detect by use of the analogue terminal 306 being coupled to the voltage divider 401 whether a DUT 151 is contacted to the socket 101 or if not. The three address terminals 303, 304, 305, and the analogue terminal 306 may be driven digitally or with analogue signals. The working principle of the voltage divider 401 is explained in more detail in Fig.4 and the principles of the electrical addressing device 360 are explained with Fig.5 and table 1.

Fig.4 shows the principle of the DUT detection (in accordance with the circuitry of Fig.3) using a resistive voltage divider 401. For a typical resistive voltage divider 401 having identical resistance values the voltage at the voltage divider 401 may be given at VCC/2 if VCC is the power supply voltage. The analogue terminal 306 of microcontroller slave 300 is coupled to the power supply 326 via the pull up resistor 316, so that the voltage of e.g. 5V is sensed, if no other circuit is involved. However, between the analogue terminal 306 and the pull up resistor 316 there is a branch circuit leading to the detection resistor 356. The detection resistor 356 is coupled to the grounding 317 if there is a DUT 151 contacted to the socket 101. To achieve this, a grounding plate 152 of the DUT may be contacted via the socket 101 (shown in Fig.3). Alternatively, two DUT internally shorted contact terminals 151a, 151b may be contacted by two contacts 101a, 101b of the socket 101, wherein one contact terminal 151a is coupled to the detection resistor 316 and the other contact terminal 151b is coupled to the grounding 317. The result -, if both resistors, the pull up resistor 316 and the detection resistor 356 have a value of 10 kOhm, - may be a voltage value of 2.5 V in case a DUT 151 is contacted to the socket 101. If no DUT 151 is contacted to the socket 101 then, as mentioned above, the circuit branch with the detection resistor 356 is open and the sensed voltage may here be VCC=5 V (the voltage value for VCC given by the power supply 326 via the pull up resistor 316 may vary from +3.3V to +5.5V). Thus, the typical mechanism of a voltage divider 401 may be used to detect whether a DUT 151 is contacted to the socket 101, or not. The microcontroller slave 300 which detects the voltage values may send a digitalized signal of the detection result to the microcontroller master 320 using an SDA line and using the SDA terminal 302. Hence, even during a so called index time, if no DUT 151 is regularly contacted to the socket 101 and hence the tester 190 has no access to the DUT 151, the microcontroller slave 300 may sense that the DUT 151 is contacted or is not contacted to the socket 101. As a consequence, the sensing of the DUT 151 may be independent from of the tester 190.

Fig.5 shows a circuit arrangement comprising a plurality of sites 501 to 516. Each of the sites 501 to 516 comprises the DUT detection as described with Fig.4 and each of the sites 501 to 516 is coupled to the SCL terminal 321 and the SDA terminal 322 of the microcontroller master 320 (see Fig.3). As depicted, each site 501 to 516 comprises a microcontroller slave 501m to 516m, a first address terminal 501a to 516a, a second address terminal 501b to 516b, and a third address terminal 501c to 516c, respectively. However, each of the three terminals of one respective site 501 to 516 may be connected in a different way in comparison to each other of the sites 501 to 516. Table 1 makes clear that for the first 8 sites 501 to 508 the three address terminals are either connected to grounding or are open. Therefore, there are 2³=(2*2*2)=8 possible different ways of circuitry for the first 8 sites 501 to 508 using "grounding" or "open", which correspond to "low" or "high" resistance values on the three address terminals.
The second address terminals 509b to 512b of the sites 509 to 512 may be coupled to grounding via address resistors 509d to 512d, having each the identical resistance values. Same holds for the sites 513 to 516, where the respective second address terminals 513b to 516b are coupled to grounding via the address resistors 513d to 516d, having also identical resistance values, respectively. However, the resistance value of the first group of address resistors 509d to 512d may be sufficiently different from the resistance value of the second group of address resistors 513d to 516d, so that each of the microcontroller slaves of the first group 509m to 512m may sense different values compared to the sensed resistance values each of the microcontroller slaves of the second group 513m to 516m. For the first group of 4 microcontroller slaves 509m to 512m there are only 2²=(2*2)=4 possible ways left to change the respective first and third address terminals between grounding and open. Same holds for the second group of 4 microcontroller slaves 513m to 516m.

Including the explained Fig.5 the table 1 makes it clear how every site 501 to 516 is electrically addressed using the different values "high", "low" or specific resistance values for the address resistors 509d to 516d. The electrical addressing device 360 is different for every site 501 to 516 and the electrical addressing device 360 is fixedly coupled to the sites 501 to 516 and not to the microcontroller slaves 501m to 516m or sockets 101, 102, respectively. It is important to mention that the microcontroller slaves 501m to 516m or sockets may be exchanged from one site to another site. Since each of the microcontroller slaves 501m to 516m may have a memory which has stored the information given by table 1 and since the electrical addressing device 360 may not change when the microcontroller slaves 501m to 516m are changed from one site to another site, each of the microcontroller slaves 501m to 516m may sense the specific electrical addressing device 360 of the site or position to which he has been attached to. As a consequence, the sockets comprising each one a microcontroller slave 300 may be exchanged from one site to another or from one handler to another and still the socket having the stored ID may be recognized at any specific position or site. In combination with the individual ID for each socket that is stored on each microcontroller slave 300 there is a way given to retrace automatically the use of any socket no matter to which site the respective socket is attached to. The I2C bus allows for addressing device 360 up to 126 sub-units or microcontroller slaves to one microcontroller master.

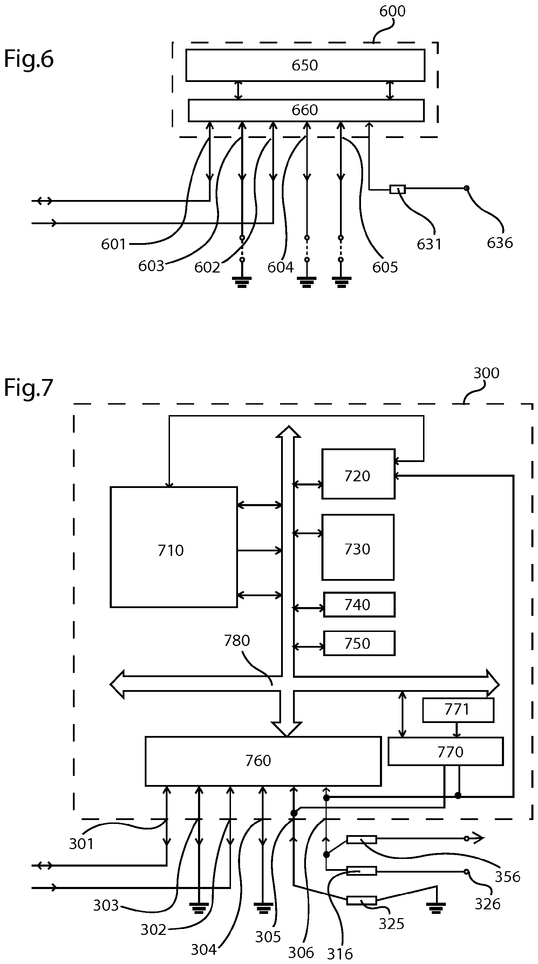

Fig.6 and Fig.7 show that there is a difference when an EEPROM 600 or a microcontroller slave 300 is used. However, both the EEPROM 600 and the microcontroller slave 300 may be compatible to the requirements of the I2C bus.

Fig.6 shows an EEPROM 600 comprising a memory unit 650 and an I2C compatible port 660. In the memory unit 650 an ID for the respective socket is stored to which the EEPROM 600 is attached to. By means of the port 660 the ID may be submitted. For this purpose the EEPROM 660 may provide an SDA terminal 602 which is coupled to a microcontroller master 320. Further, the EEPROM 600 comprises an SCL terminal 601 for timing purposes and three address terminals, namely the first address terminal 603, the second address terminal 604 and the third address terminal 605. Since, each of the address terminals may be digital terminals, the three address terminals may be either coupled to a jumper (low) or be open (high). As explained in accordance with Fig.5 and in accordance with the sites 501 to 508 from table 1 the electrical addressing device 360 using "low" or "high" may only address 8 subunits or sockets, respectively. Therefore, the use of the EEPROM 500 is limited to 8 sockets per positioning system or per microcontroller master 320, respectively. Furthermore, EEPROM 600 is coupled to a power supply 636 via a pull up resistor 631.

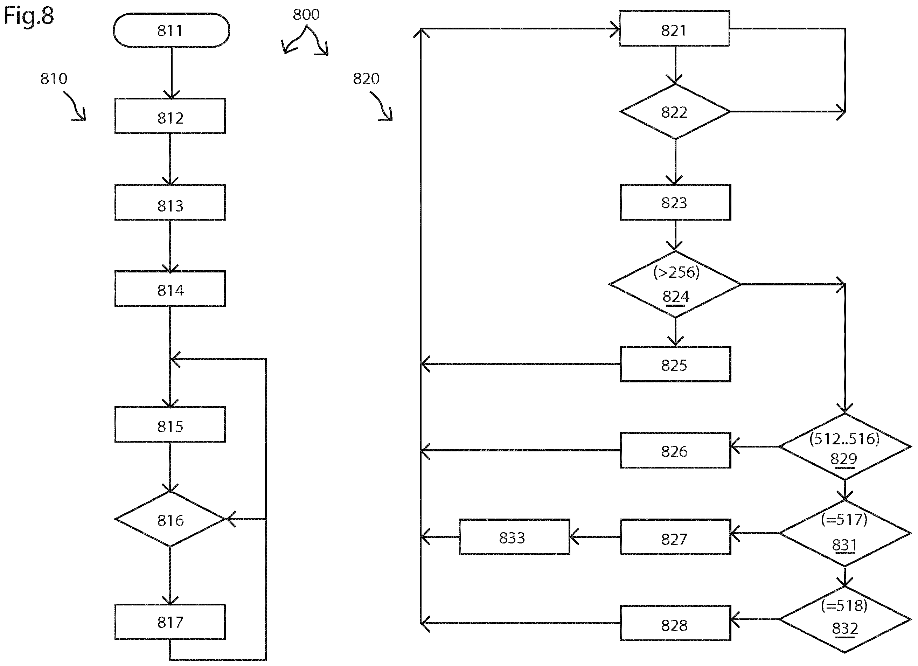

Fig.7 shows the microcontroller slave 300 in a simplified manner. The microcontroller slave 300 comprises a CPU 710 where the program code is stored and where the logic is executed. Further, the microcontroller slave 300 comprises a timing & control unit 720 for purposes of time relevant tasks. The microcontroller slave 300 further comprises a universal serial interface 730 for providing the I2C bus and an interrupt unit 740 which is important for the program cycles (see Fig.8) which are executed. Moreover, on an internal EEPROM 750 the ID may be stored directly or in an encoded way. The microcontroller slave 300 comprises an AD converter 770 and a temperature sensor 771. The temperature sensor 771 may submit an analogue signal of the sensed temperature to the AD converter 770, which in turn may generate a digitalized signal corresponding to the submitted analogue signal. Analogously to the EEPROM 600, the microcontroller slave 300 may comprise a port 760 being compatible to the I2C bus requirements. Each of the components of the microcontroller slave 300, the CPU 710, the timing & control unit 720, the universal serial interface 730, the interrupt unit 740, the internal EEPROM 750, the port 760, and the AD converter 770 is coupled to an internal 8-bit bus 780. Since each of the address terminals 303, 304, 305 may be driven with analogue signals each of these terminals, as well as the analogue terminal 306 may be coupled to the AD converter 770. Hence, the microcontroller slave 300 may determine the specifically encoded site 501 to 516 where the microcontroller slave 300 or the respective socket is attached to by using the AD converter 770.

Fig.8 shows a flow chart 800 of the program which is executed on the microcontroller slave 300. The flow chart 800 may be divided into two subprograms which are a start & sense procedure 810 and a query procedure 820. First, in a "Power on" step 811, the microcontroller slave 300 may be powered up. Then the I2C bus and the internal analogue hardware may be initialized (step 812). The AD converter 770 then may read the state of the three address terminals 303, 304, 305. Further, to obtain the sub-address of the respective site (which could be sites 501 to 516) the table 1 is used which information thereto was stored in EEPROM 750, wherein both last steps happen in step 813. As a consequence, the microcontroller slave 300 has gained the sub-address or digital address signal of the site to which socket 101 or microcontroller slave 300 is attached to (step 813). Then in interrupt enable step 814 the microcontroller slave 300 is brought into the state where interrupts are enabled so that digital information may be written on the EEPROM 750 and may be read out from the EEPROM 750. Subsequently, a loop starts where the microcontroller permanently observes whether a DUT 151 is coupled to the socket 101 or not. During any substep of this loop the microcontroller may be interrupted and further the query procedure 820 may be executed if there is an interrupt initialized by the interrupt unit 740. If no interruption is made, the loop processes following steps: In "reading & evaluation" 815 the microcontroller slave 300 evaluates device insertion detection wherein a preset of 1 is set. In the following step 816 the microcontroller slave 300 actually senses if the voltage value is lower than 2.7 V. If the voltage value is lower than 2.7 V then (as described for Fig.4) actually a DUT 151 is contacted to the socket 101, the preset flag 1 remains, and the loop starts again with 815. If the voltage value is 2.7 V or higher then no DUT is contacted to the socket 101 and the flag or respective latch is set to 0 (step 817) and a return to step 815 follows. Thus, the microcontroller slave 300 permanently observes if a DUT is contacted to the socket 101, or not, and the respective flag or latch is set to 1 or 0, respectively.

Since the microcontroller slave 300 is enabled to be interrupted (step 814) an interrupt may take place at any time of the steps 815 to 817. If the microcontroller master 320 transmits an interrupt signal to the microcontroller slave 300 the query procedure 820 starts with acknowledgment of the received interrupt 821. Then, in step 822 a query is made, whether the sub-address obtained in step 813 is correct. If not, the slope returns to step 822 awaiting the interrupt for the right sub-address (sites). If the sub-address is correct then the procedure jumps to decoding a 16-bit address from the I2C bus (step 823). If the 16-bit address is equal or lower than 256 then the content of the EEPROM 750 is required and step 829 follows which gives out the content of the EEPROM 750. If the 16-bit address is higher than 256 and is between 512 to 516 then the temperature digits may be given out (step 826). If the 16-bit address is not between 512 and 516, but equal to 517 step 827 and accordingly the DUT detection flag is given out (step 827). Following this, the DUT detection flag is again set to preset value 1 (step 833), and the procedure jumps back to step 821. If the 16-bit address is not 517 but equal to 518, then a CRC checksum is given out (step 828) on the I2C bus and the procedure jumps back to step 821. Thus, the microcontroller master 320 may request serially information from the microcontroller slave 300 by first determining whether it is the right sub-address (or site), and then, second, getting submitted the information about the EEPROM content (step 825), about the measured temperature (step 826), the sensed DUT (151), or not (step 827), and the CRC checksum (step 828). So, the program running on the microcontroller master 320 determines which information from the microcontroller slave 300 may be submitted via the I2C bus.

## Claims

1. A positioning device (380) for determining a site (501-516) of an exchangeable wear part (101, 102, 201a-d, 141, 142) of a handler (180), wherein the positioning device (380) comprises:
an electronic component (300, 600) arranged on or at the wear part (101, 102, 201a-d, 141, 142), and
an electrical addressing device (360) being readable for the electronic component (300, 600), wherein
the electronic component (300, 600) is electrically connected to the electrical addressing device (360) and wherein the electronic component (300, 600) fulfils specifications of a bus, wherein
the electronic component (300, 600) is configured to read out electrical characteristics of the electrical addressing device (360) so that by the electronic component (300, 600) the site (501-516) which corresponds to the electrical addressing device (360) is obtainable.

2. The positioning device (380) according to claim 1, wherein
the electronic component (300, 600) is adapted to transform an addressing of the electrical addressing device (360) into a digital address signal and to transmit the digital address signal via the bus, wherein
the electrical addressing device (360) is configured to be sensed by the electronic component (300, 600), and wherein
the electronic component (300, 600) transforms a physically or electrically given information or state into a digital address signal which corresponds to the specific electrical addressing device (360).

3. The positioning device (380) according to claims 1 or 2, wherein
the electrical addressing device (360) is unique for each site (501-516) of the handler (180).

4. The positioning device (380) according to any one of the claims 1 to 3, wherein the electrical addressing device (360) comprises jumpers (314), and/or resistors (313), and/or capacitors, and/or coils, being electrically coupled to address terminals (303, 304, 305) of the electronic component (300, 600).

5. The positioning device (380) according to claim 4, further comprising
an interface board (130, 135, 330), wherein at least one of the group of the jumpers (314), the resistors (313), the capacitors, the coils, and the wear part (101, 102, 201a-d, 141, 142) is arranged on or at the interface board (130, 135, 330).

6. The positioning device (380) according to any one of the claims 1 to 5, wherein the specification of the bus is an I2C bus.

7. The positioning device (380) according to any one of the claims 1 to 6, wherein the electronic component (300, 600) is an EEPROM (600) on which an ID of the wear part (101, 102, 201a-d, 141, 142) is stored.

8. The positioning device (380) according to any one of the claims 1 to 6, wherein the electronic component (300, 600) is a microcontroller slave (300) comprising an internal EEPROM (750) on which an ID of the wear part (101, 102, 201a-d, 141, 142) is stored.

9. The positioning device (380) according to any one of the claims 1 to 8, wherein the positioning device (380) further comprises a data matrix code (309) being attached to the wear part (101, 102, 201a-d, 141, 142).

10. The positioning device (380) according to claim 8, wherein
the microcontroller slave (300)
comprises a temperature sensor (771) to determine a temperature value on the wear part (101, 102, 201a-d, 141, 142) and
is adapted to send a digitalized temperature signal via the bus.

11. The positioning device (380) according to any one of the claims 8 to 10,
wherein
the wear part (101, 102, 201a-d, 141, 142) is a socket (101, 102) and the microcontroller slave (300) comprises an analogue terminal (306), and wherein a voltage divider (401) is coupled to the analogue terminal (306) so that the microcontroller slave (300) can sense if a DUT (151, 152) is contacted to the socket (101, 102), or if no DUT (151, 152) is contacted to the socket (101, 102).

12. A positioning system (390) for determining a site (501-516) of a wear part (101, 102, 201a-d, 141, 142) of a handler (180), wherein the positioning system (390) comprises
a plurality of the positioning devices (380) according to any one of the claims 8 to 11 and
a microcontroller master (320) fulfilling the specifications of the bus and being coupled to the electronic component (300, 600) via the bus.

13. The positioning system (390) according to claim 12, wherein
the microcontroller master (320) is programmed to request from the microcontroller slave (300) at least one of the group of the digital address signal, the digitalized temperature signal, the ID, and a digitalized signal of a contacted DUT (151, 152) or of no contacted DUT (151, 152).

14. The positioning system (390) according to claims 12 or 13, wherein
the microcontroller master (320) is arranged on or at a tester (190).

15. The positioning system (390) according to any one of the claims 12 to 14, wherein
at least one of the group of the digital address signal, the digitalized temperature signal, the ID, and a digitalized signal of a contacted DUT (151, 152) or of no contacted DUT (151, 152), is stored on a database.

## Patentansprüche

1. Eine Positionierungsvorrichtung (380) zum Bestimmen eines Standorts (501-516) eines austauschbaren Verschleißteils (101, 102, 201a-d, 141, 142) eines Handlers (180), wobei die Positionierungsvorrichtung (380) aufweist:
ein elektronisches Bauelement (300, 600), welches auf oder an dem Verschleißteil (101, 102, 201a-d, 141, 142) angeordnet ist, und
eine elektrische Addressierungsvorrichtung (360), welche für das elektronische Bauelement (300, 600) lesbar ist, wobei
das elektronische Bauelement (300, 600) mit der elektrischen Addressierungsvorrichtung (360) elektrisch verbunden ist und wobei das elektronische Bauelement (300, 600) Spezifikationen eines Busses erfüllt, wobei das elektronische Bauelement (300, 600) eingerichtet ist, elektrische Eigenschaften der elektrischen Addressierungsvorrichtung (360) auszulesen, so dass der Standort (501-516), welcher der elektrischen Addressierungsvorrichtung (360) entspricht, mittels des elektronischen Bauelements (300, 600) erhältlich ist.

2. Die Positionierungsvorrichtung (380) gemäß Anspruch 1, wobei
das elektronische Bauelement (300, 600) ausgebildet ist, eine Adressierung der elektrischen Addressierungsvorrichtung (360) in ein digitales Adresssignal umzuwandeln und das digitale Adresssignal über den Bus zu übertragen, wobei die elektrische Addressierungsvorrichtung (360) eingerichtet ist, von dem elektronischen Bauelement (300, 600) erkannt zu werden, und wobei das elektronische Bauelement (300, 600) eine/n physikalisch oder elektrisch vorgegebene/n Information oder Zustand in ein digitales Adresssignal, welches der spezifischen elektrischen Addressierungsvorrichtung (360) entspricht, umzuwandeln.

3. Die Positionierungsvorrichtung (380) gemäß Anspruch 1 oder 2, wobei
die elektrische Addressierungsvorrichtung (360) für jeden Standort (501-516) des Handlers (180) eindeutig ist.

4. Die Positionierungsvorrichtung (380) gemäß einem der Ansprüche 1 bis 3, wobei
die elektrische Addressierungsvorrichtung (360) Kurzschlussbrücken (314) und/oder Widerstände (313) und/oder Kondensatoren und/oder Spulen aufweist, welche mit Adressanschlüssen (303, 304, 305) des elektronischen Bauelements (300, 600) elektrisch gekoppelt sind.

5. Die Positionierungsvorrichtung (380) gemäß Anspruch 4, ferner aufweisend
eine Schnittstellenplatine (130, 135, 330), wobei mindestens eine/einer aus der Gruppe der Kurzschlussbrücken (314), der Widerstände (313), der Kondensatoren, der Spulen und der Verschleißteile (101, 102, 201a-d, 141, 142) auf oder an der Schnittstellenplatine (130, 135, 330) angeordnet ist.

6. Die Positionierungsvorrichtung (380) gemäß einem der Ansprüche 1 bis 5, wobei
die Spezifikation des Busses ein I2C Bus ist.

7. Die Positionierungsvorrichtung (380) gemäß einem der Ansprüche 1 bis 6, wobei
das elektronische Bauelement (300, 600) ein EEPROM (600) ist, auf welchem eine ID des Verschleißteils (101, 102, 201a-d, 141, 142) gespeichert ist.

8. Die Positionierungsvorrichtung (380) gemäß einem der Ansprüche 1 bis 6, wobei
das elektronische Bauelement (300, 600) ein Mikrocontroller-Folgegerät (300) ist, welches einen internen EEPROM (750) aufweist, auf welchem eine ID des Verschleißteils (101, 102, 201a-d, 141, 142) gespeichert ist.

9. Die Positionierungsvorrichtung (380) gemäß einem der Ansprüche 1 bis 8, wobei
die Positionierungsvorrichtung (380) ferner einen Datenmatrix-Code (309) aufweist, der an dem Verschleißteil (101, 102, 201a-d, 141, 142) befestigt ist.

10. Die Positionierungsvorrichtung (380) gemäß Anspruch 8, wobei
das Mikrocontroller-Folgegerät (300) einen Temperatursensor (771) zum Bestimmen eines Temperaturwerts auf dem Verschleißteil (101, 102, 201a-d, 141, 142) aufweist und ausgebildet ist, ein digitalisiertes Temperatursignal über den Bus zu senden.

11. Die Positionierungsvorrichtung (380) gemäß einem der Ansprüche 8 bis 10, wobei
das Verschleißteil (101, 102, 201a-d, 141, 142) eine Steckerbuchse (101, 102) ist und das Mikrocontroller-Folgegerät (300) einen analogen Anschluss (306) aufweist, und wobei ein Spannungsteiler (401) mit dem analogen Anschluss (306) gekoppelt ist, so dass das Mikrocontroller-Folgegerät (300) erkennen kann, ob ein DUT (151, 152) mit der Steckerbuchse (101, 102) kontaktiert ist, oder ob kein DUT (151, 152) mit der Steckerbuchse (101, 102) kontaktiert ist.

12. Ein Positionierungssystem (390) zum Bestimmen eines Standorts (501-516) eines Verschleißteils (101, 102, 201a-d, 141, 142) eines Handlers (180), wobei das Positionierungssystem (390) aufweist:
eine Mehrzahl von Positionierungsvorrichtungen (380) gemäß einem der Ansprüche 8 bis 11 und
einen Mikrocontroller-Master (320), welcher die Spezifikationen des Busses erfüllt und über den Bus mit dem elektronischen Bauelement (300, 600) gekoppelt ist.

13. Das Positionierungssystem (390) gemäß Anspruch 12, wobei
der Mikrocontroller-Master (320) programmiert ist, von dem Mikrocontroller-Folgegerät (300) mindestens eines aus der Gruppe des digitalen Adresssignals, des digitalisierten Temperatursignals, der ID und eines digitalisierten Signals eines kontaktierten DUT (151, 152) oder keines kontaktierten DUT (151, 152) anzufordern.

14. Das Positionierungssystem (390) gemäß Anspruch 12 oder 13, wobei
der Mikrocontroller-Master (320) auf oder an einem Prüfgerät (190) angeordnet ist.

15. Das Positionierungssystem (390) gemäß einem der Ansprüche 12 bis 14, wobei
mindestens eines aus der Gruppe des digitalen Adresssignals, des digitalisierten Temperatursignals, der ID und eines digitalisierten Signals eines kontaktierten DUT (151, 152) oder keines kontaktierten DUT (151, 152) auf einer Datenbank gespeichert ist.

## Revendications

1. Dispositif de positionnement (380) pour déterminer un site (501-516) d'une pièce d'usure échangeable (101, 102, 201a-d, 141, 142) d'un manipulateur (180), dans lequel le dispositif de positionnement (380) comprend:
un composant électronique (300, 600) agencé sur ou au niveau de la pièce d'usure (101, 102, 201a-d, 141, 142), et
un dispositif d'adressage électrique (360) étant lisible pour le composant électronique (300, 600), dans lequel
le composant électronique (300, 600) est électriquement raccordé au dispositif d'adressage électrique (360) et dans lequel le composant électronique (300, 600) remplit les spécifications d'un bus, dans lequel
le composant électronique (300, 600) est configuré pour lire des caractéristiques électriques du dispositif d'adressage électrique (360) de sorte que par le composant électronique (300, 600) le site (501-516) qui correspond au dispositif d'adressage électrique (360) puisse être obtenu.

2. Dispositif de positionnement (380) selon la revendication 1, dans lequel
le composant électronique (300, 600) est adapté pour transformer un adressage du dispositif d'adressage électrique (360) en un signal d'adresse numérique et pour transmettre le signal d'adresse numérique via le bus, dans lequel
le dispositif d'adressage électrique (360) est configuré pour être détecté par le composant électronique (300, 600), et dans lequel
le composant électronique (300, 600) transforme une information ou un état donnés physiquement ou électriquement en un signal d'adresse numérique qui correspond au dispositif d'adressage électrique (360) spécifique.

3. Dispositif de positionnement (380) selon les revendications 1 ou 2, dans lequel
le dispositif d'adressage électrique (360) est unique pour chaque site (501-516) du manipulateur (180).

4. Dispositif de positionnement (380) selon l'une quelconque des revendications 1 à 3, dans lequel
le dispositif d'adressage électrique (360) comprend des cavaliers (314), et/ou des résistances (313), et/ou des condensateurs, et/ou des bobines, étant électriquement couplés à des bornes d'adresse (303, 304, 305) du composant électronique (300, 600).

5. Dispositif de positionnement (380) selon la revendication 4, comprenant en outre
une carte d'interface (130, 135, 330), dans lequel au moins l'un du groupe des cavaliers (314), des résistances (313), des condensateurs, des bobines, et de la pièce d'usure (101, 102, 201a-d, 141, 142) est agencé sur ou au niveau de la carte d'interface (130, 135, 330).

6. Dispositif de positionnement (380) selon l'une quelconque des revendications 1 à 5, dans lequel
la spécification du bus est un bus I2C.

7. Dispositif de positionnement (380) selon l'une quelconque des revendications 1 à 6, dans lequel
le composant électronique (300, 600) est une EEPROM (600) sur laquelle un identifiant de la pièce d'usure (101, 102, 201a-d, 141, 142) est stocké.

8. Dispositif de positionnement (380) selon l'une quelconque des revendications 1 à 6, dans lequel
le composant électronique (300, 600) est un esclave de microcontrôleur (300) comprenant une EEPROM interne (750) sur laquelle un identifiant de la pièce d'usure (101, 102, 201a-d, 141, 142) est stocké.

9. Dispositif de positionnement (380) selon l'une quelconque des revendications 1 à 8, dans lequel
le dispositif de positionnement (380) comprend en outre un code matriciel de données (309) étant fixé à la pièce d'usure (101, 102, 201a-d, 141, 142).

10. Dispositif de positionnement (380) selon la revendication 8, dans lequel
l'esclave de microcontrôleur (300)
comprend un capteur de température (771) pour déterminer une valeur de température sur la pièce d'usure (101, 102, 201a-d, 141, 142) et
est adapté pour envoyer un signal de température numérisé via le bus.

11. Dispositif de positionnement (380) selon l'une quelconque des revendications 8 à 10,
dans lequel
la pièce d'usure (101, 102, 201a-d, 141, 142) est une prise (101, 102) et l'esclave de microcontrôleur (300) comprend une borne analogue (306), et dans lequel un réducteur de tension (401) est couplé à la borne analogue (306) de sorte que l'esclave de microcontrôleur (300) puisse détecter si un DUT (151, 152) est mis en contact avec la prise (101, 102), ou si aucun DUT (151, 152) n'est mis en contact avec la prise (101, 102) .

12. Système de positionnement (390) pour déterminer un site (501-516) d'une pièce d'usure (101, 102, 201a-d, 141, 142) d'un manipulateur (180), dans lequel le système de positionnement (390) comprend
une pluralité de dispositifs de positionnement (380) selon l'une quelconque des revendications 8 à 11 et
un microcontrôleur maître (320) remplissant les spécifications du bus et étant couplé au composant électronique (300, 600) via le bus.

13. Système de positionnement (390) selon la revendication 12, dans lequel
le microcontrôleur maître (320) est programmé pour demander à l'esclave de microcontrôleur (300) au moins l'un du groupe du signal d'adresse numérique, du signal de température numérisé, de l'ID et d'un signal numérisé d'un DUT (151, 152) mis en contact ou d'un DUT (151, 152) non mis en contact.

14. Système de positionnement (390) selon les revendications 12 ou 13, dans lequel
le microcontrôleur maître (320) est agencé sur ou au niveau d'un testeur (190).

15. Système de positionnement (390) selon l'une quelconque des revendications 12 à 14, dans lequel
au moins l'un du groupe du signal d'adresse numérique, du signal de température numérisé, de l'ID et d'un signal numérisé d'un DUT (151, 152) mis en contact ou d'un DUT (151, 152) non mis en contact, est stocké sur une base de données.
